**Europäisches Patentamt**

**European Patent Office**

**Office européen des brevets**

(19)

(11) Veröffentlichungsnummer: **0 037 966**
A1

# EUROPÄISCHE PATENTANMELDUNG

(12)

(21) Anmeldenummer: **81102469.4**

(22) Anmeldetag: **01.04.81**

(51) Int. Cl.³: **G 11 B 5/38**

(30) Priorität: **15.04.80 DE 3014469**

(43) Veröffentlichungstag der Anmeldung: **21.10.81**
**Patentblatt 81/42**

(84) Benannte Vertragsstaaten: **AT BE CH FR GB IT LI LU NL SE**

(71) Anmelder: **SIEMENS AKTIENGESELLSCHAFT Berlin und München, Postfach 22 02 61, D-8000 München 22 (DE)**

(72) Erfinder: **Boehner, Michael, Dipl.-Ing., Anzengruberstrasse 18, D-8014 Neubiberg (DE)**
Erfinder: **Haudek, Helmut, Dr., Wilramstrasse 13, D-8000 München 80 (DE)**
Erfinder: **Metzdorf, Werner, Dipl.-Phys., Franz-Schubert-Strasse 8, D-8025 Unterhaching (DE)**

(54) **Magnetoresistiver Sensor.**

(57) Die Erfindung betrifft einen magnetoresistiven Sensor, bestehend aus einem stromdurchflossenen Streifen (4) aus ferromagnetischem Material, der in einem ersten Abschnitt (9) mit einer Mehrzahl von Leiterbahnen (11) versehen ist, die zu der Streifenlängsachse einen ersten Winkel einschließen, und in einem zweiten Abschnitt (10) entsprechende, unter einem anderen Winkel verlaufende Leiterbahnen (12) aufweist. Bei solchen Sensoren wird eine Linearisierung der Kennlinie angestrebt. Das wird erfindungsgemäß dadurch erreicht, daß die beiden Abschnitte (9, 10) des Streifens (4) von konstanten Strömen in zueinander entgegengesetzten Richtungen durchflossen werden, wobei die die Ströme aufnehmenden (abgebenden) Enden beider Abschnitte (9, 10) miteinander verbunden sind und die die Ströme abgebenden (aufnehmenden) Enden an den Sensorausgang geführt sind. Der Anwendungsbereich umfaßt insbesondere Leseköpfe für Informationsspuren.

EP 0 037 966 A1

0037966

SIEMENS AKTIENGESELLSCHAFT     Unser Zeichen
Berlin und München            VPA

                              EU P 7044 E

Magnetoresistiver Sensor

Die Erfindung bezieht sich auf einen magnetoresistiven
Sensor nach dem Oberbegriff des Anspruchs 1. Bei einem
Sensor ändert der Streifen aus ferromagnetischem
Material seinen Widerstand in Abhängigkeit von der
Stärke eines abgetasteten Magnetfeldes. Die Widerstandsänderung ergibt eine Änderung der Spannung, die an den
von einem konstanten Strom durchflossenen Streifen
abfällt und die das Sensorsignal darstellt.

Ein Sensor dieser Art ist aus den IEEE Transactions on
Magnetics, Vol. MAG-11, No. 5, Sept. 1975, Seiten 1215
bis 1217 bekannt. Die auf dem ferromagnetischen Streifen
aufgebrachten Leiterbahnen, die in der englischsprachigen
Fachliteratur auch als "barber poles" bezeichnet
werden, bewirken eine Drehung der Stromrichtung im
Streifen, da sich zwischen den einzelnen Leiterbahnen
Strompfade ergeben, die senkrecht zu den Rändern derselben aus- bzw. eintreten. Der Winkel zwischen der
gedrehten Stromrichtung und einer in Längsrichtung
des Streifens orientierten Magnetisierung, der z. B.
zu 45° gewählt wird, führt dazu, daß auf der Sensor -
kennlinie, die die Abhängigkeit des Sensorsignals von
der Stärke des den Streifen beaufschlagenden senkrecht
zur Längsrichtung orientierten Magnetfeldes angibt,
ein im linearen Kennlinienbereich liegender Arbeitspunkt
eingenommen wird.

Der magnetoresistive Streifen dieses bekannten Sensors
weist zwei von ein und demselben Strom in gleicher
Richtung durchflossene Abschnitte auf, deren Leiterbahnen mit der Längsrichtung jeweils unterschiedliche, sich gegenseitig zu 180° ergänzende Winkel einschließen. Nur an den Enden des Streifens sind dabei Anschlüsse zur Abnahme des Sensorsignals und zur Stromzuführung vorgesehen. Da das abgetastete Magnetfeld von der Informationsspur eines magnetischen Aufzeichnungsträgers herrührt wirken sich zeitliche Verschiebungen des Sensors gegenüber dieser Informationsspur, bei denen nur ein Teil des Sensors mit dem abzutastenden Magnetfeld beaufschlagt wird, auf die Amplitude und das Vorzeichen des Sensorsignals aus. Das Sensorsignal enthält somit auch eine Information über eine etwaige Fehlposition des Sensors in Bezug auf die Informationsspur, die zu einer Positionskorrektur herangezogen werden kann. In der korrigierten Lage des Sensors befindet sich dann beispielsweise nur einer der Abschnitte über der abzutastenden Informationsspur.

Aus den IEEE Transactions on Magnetics, Vol. MAG-13, No. 5, Sept. 1977, Seiten 1466 bis 1468, ist es andererseits bekannt, daß bei einem magnetoresistiven Sensor, dessen Streifen mit zur Längsrichtung schrägverlaufenden untereinander parallelen Leiterbahnen versehen ist, eine gleichsinnige Magnetisierungsdrehung durch ein "inneres" Magnetfeld begünstigt wird, das sich in dem Streifen aufgrund des in den Leiterbahnen fließenden Stromes ergibt. Voraussetzung hierfür ist lediglich, daß der Streifen von einem relativ großen Sensorstrom durchflossen wird, der z. B. 1 bis 50 mA beträgt.

Nachteilig ist es, daß bei einem Sensor, dessen magnetoresistiver Streifen mit schräg zur Streifenlängsrichtung verlaufenden Leiterbahnen versehen ist, in den Randzonen des Streifens Strompfade entstehen, die von der gewünschten Stromrichtung abweichen. Hieraus ergeben sich Nichtlinearitäten der Sensorkennlinie.

0037966
80 P 7 0 4 4 E

Der Erfindung liegt die Aufgabe zugrunde, die Kennlinie eines Sensors der eingangs genannten Art weitgehend zu linearisieren. Diese Aufgabe wird durch die im Anspruch 1 gekennzeichneten Merkmale gelöst.

Der mit der Erfindung erzielbare Vorteil besteht insbesondere darin, daß sich die zweiten Oberwellen und alle weiteren geradzahligen Oberwellen der Sensorteilsignale, die sich für jeden der beiden Streifenabschnitte aufgrund der Nichtlinearitäten der ihm zuzuordnenden Kennlinie ergeben, gegenseitig kompensieren, so daß das von dem gesamten Sensor abgegebene Sensorsignal von diesen Oberwellen befreit ist. Andererseits addieren sich die linearen Anteile der von den beiden Streifenabschnitten herrührenden Sensorteilsignale. Der Sensor nach der Erfindung zeichnet sich weiterhin dadurch aus, daß etwaige in den Streifenabschnitten entstehende, temperaturabhängige Widerstandsänderungen ebenfalls kompensiert werden. Da die in Streifenlängsrichtung liegenden Komponenten der inneren Magnetfelder in beiden Streifenabschnitten gleichsinnig orientiert sind, erfolgt beim Nulldurchgang des abgetasteten Magnetfeldes eine Rückdrehung der Magnetisierung innerhalb des gesamten Streifens in ein und dieselbe Richtung, so daß im linearen Aussteuerungbereich des Sensors keine Domänenaufspaltungen auftreten. Zudem können die die Streifenabschnitte durchfließenden Ströme beliebig groß gewählt werden, so lange die noch zulässige Stromdichte des magnetoresistiven Materials nicht überschritten wird, da die Form der Sensorkennlinie von der Größe der inneren Magnetfelder weitgehend unabhängig ist.

In den Ansprüchen 2 bis 8 sind vorteilhafte Weiterbildungen und Anwendungen der Erfindung angegeben.

0037966
80 P 7044 E

Die Erfindung wird nachfolgend anhand der Zeichnung näher erläutert. Dabei zeigt:

Fig. 1    einen erfindungsgemäßen magnetoresistiven Sensor,

Fig. 2    eine schaltungstechnische Ausgestaltung des Sensors nach Fig. 1,

Fig. 3    die Kennlinie des Sensors nach Fig. 1,

Fig. 4    eine Weiterbildung des Sensors nach Fig. 1,

Fig. 5    einen anderen erfindungsgemäßen Sensor und

Fig. 6    eine schematische Darstellung zur Erläuterung von Fig. 5.

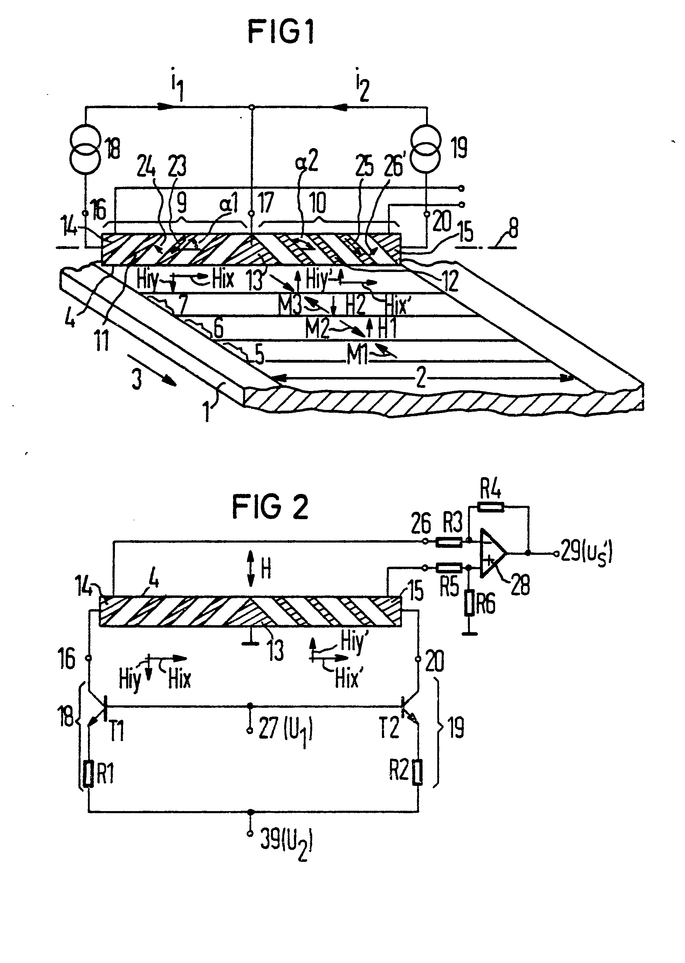

In Fig. 1 wird ein bandförmiger magnetischer Aufzeichnungsträger 1, der eine Informationsspur 2 aufweist, in Richtung des Pfeils 3 an einen ortsfesten Streifen 4 aus ferromagnetischem Material vorbeigeführt. Die Informationsspur ist abschnittsweise in entgegengesetzten Richtungen magnetisiert, wie durch die in den Abschnitten 5, 6 und 7 eingezeichneten Pfeile M1, M2 und M3 angedeutet ist. An der Grenze der Abschnitte 5 und 6 ergibt sich ein durch den Vektor H1 dargestelltes magnetisches Streufeld, das aus der Informationsspur 2 senkrecht nach oben austritt, während an der Grenze der Abschnitte 6 und 7 ein durch den Vektor H2 veranschaulichtes Streufeld in die Informationsspur eintritt. Durch die Bewegung des Trägers 1 in die Richtung 3 wird der Streifen 4 mit einem magnetischen Feld H beaufschlagt, das in vertikaler Richtung orientiert ist und entsprechend den jeweils abgetasteten Spurabschnitten in seiner Stärke und seinem Vorzeichen variiert.

Der magnetoresistive Streifen 4 besteht beispielsweise aus einer Ni-Fe-Legierung mit 81 bis 84 % Ni und 16 bis 19 % Fe. Seine Längsachse ist mit 8 bezeichnet. Der Streifen ist ferner in zwei Abschnitte 9 und 10 unterteilt, von denen der erste mit einer Reihe von parallel zueinander verlaufenden Leiterbahnen 11 bedeckt ist, die gegen die Längsachse 8 unter einem Winkel $\alpha 1$ von beispielsweise 45° verlaufen. Der zweite Streifenabschnitt 10 enthält Leiterbahnen 12, die dann mit der Achse 8 einen Winkel von 135° einschließen. Die Leiterbahnen 11, 12 bestehen dabei aus einem elektrisch gut leitenden Material, z. B. aus Gold. Während die einander zugekehrten und miteinander verbundenen Enden der Abschnitt 9 und 10 mit einer gemeinsamen leitenden Belegung 13 versehen sind, weisen die anderen Enden der Abschnitte 9 und 10 leitende Belegungen 14 und 15 auf. Die Belegungen 13 und 14 sind mit Anschlüssen 16 und 17 verbunden, die mit einer Konstantstromquelle beschaltet sind. Eine weitere Konstantstromquelle 19 liegt an einem Anschluß 20, der mit der Belegung 15 verbunden ist, und an dem Anschluß 17. Mit dem von 18 gelieferten Strom $i_1$ ergeben sich in den Leitbahnen 11 durch den Pfeil 23 angedeutete Ströme, die sich zwischen den Leiterbahnen jeweils in Strompfaden 24 fortsetzen, die im rechten Winkel zu den Rändern der Leiterbahnen 11 aus diesen aus- bzw. in diese eintreten. In analoger Weise ergeben sich mit dem Strom $i_2$ in den Leiterbahnen 12 jeweils Ströme 25 und Strompfade 26.

Die durch den Pfeil 23 angedeuteten Ströme in den Leiterbahnen 11 erzeugen in dem Streifenabschnitt 9 ein inneres Magnetfeld, dessen Komponente in Richtung der Achse 8 mit $H_{ix}$ bezeichnet ist. Seine hierzu senkrechte Komponente $H_{iy}$ ist nach unten gerichtet. Im Abschnitt 10 entsteht durch die Ströme 25 ein inneres Magnetfeld mit der horizontalen Komponente $H_{ix}'$ und der vertikalen nach oben gerichteten Komponente $H_{iy}'$.

Die Feldkomponenten $H_{ix}$ und $H_{ix}'$ sind gleichsinnig orientiert und begünstigen eine einheitliche, in Richtung der Achse 8 orientierte Magnetisierung des Streifens 4. Tritt ein abzutastendes Magnetfeld H auf, das in Fig. 1 durch die Vektoren $H_1$ und $H_2$ angedeutet ist, so wird die Magnetisierung des Streifens 4 entsprechend gedreht. Beim Nulldurchgang des Magnetfeldes H dreht sich aber die Magnetisierung stets gleichsinnig in die durch $H_{ix}$ und $H_{ix}'$ bestimmte Ausgangslage zurück, so daß eine Domänenaufspaltung unterbleibt. Beim Fehlen einer Domänenaufspaltung entfällt auch der Beitrag der Barkhausensprünge zum Rauschen. Die Feldkomponenten $H_{iy}$ und $H_{iy}'$ sind einander entgegengerichtet. Durch das abzutastende Magnetfeld H wird dann eine dieser Komponenten verstärkt und die andere gleichzeitig geschwächt. Damit ergeben sich in den Abschnitten 9 und 10 unterschiedliche Widerstandsänderungen. An den Belegungen 13 und 14 einerseits und den Belegungen 13 und 15 andererseits treten Spannungsänderungen unterschiedlichen Vorzeichens auf. An dem mit den Belegungen 14 und 15 verbundenen Anschlüssen 26, die den Signalausgang des Sensors darstellen, ist dann die Summe dieser Spannungsänderungen als Sensorsignal $u_s$ abgreifbar. Bei Abweichungen der Widerstandswerte der Streifenabschnitte 9 und 10 gegeneinander kann es zweckmäßig sein, die Stromquellen 18, 19 einstellbar zu machen, um die Ströme $i_1$ und $i_2$ jeweils auf einen solchen Wert zu bringen, daß bei fehlendem, abgetasteten Magnetfeld H an beiden Streifenabschnitten 9 und 10 gleiche Spannungen abfallen.

Fig. 2 zeigt eine zweckmäßige schaltungstechnische Durchbildung der Prinzipschaltung nach Fig. 1. Dabei ist die Belegung 13 mit dem Bezugspotential beschaltet, während die Anschlüsse 16 und 20 im Kollektorkreis jeweils eines Transistors T1 bzw. T2 liegen. Die Emitter der Transistoren sind über Widerstände R1 und R2 mit einem Anschluß 39 verbunden, der mit einer konstanten

0037966

80 P 7044 E

Spannung U2 belegt ist, während der gemeinsame Basisanschluß 27 mit einer kontanten Spannung U1 beschaltet ist. Die Teile T1, R1 und 27, 39 entsprechen der Konstantstromquelle 18 von Fig. 1, die Teile T2, R2 und 27, 39 der Konstantstromquelle 19. Der obere Anschluß 26 ist über einen Widerstand R3 mit dem negativen Eingang eines Operationsverstärker 28 verbunden, dessen Ausgang 29 mit seinem negativen Eingang über einen Widerstand R4 verbunden ist. Der untere Anschluß 26 ist über einen Widerstand R5 = R3 an den positiven Eingang von 28 geführt, der über einen Widerstand R6 = R4 an das Bezugspotential gelegt ist. Bezeichnet man das Sensorteilsignal zwischen den Belegungen 13 und 14 als $u_{s1}$ und das Sensorteilsignal zwischen 13 und 15 als $u_{s2}$, so ergibt sich am Ausgang 29 von 28 ein verstärktes Sensorsignal $u_s'$ folgender Größe:

$$u_s' = (u_{s1} - u_{s2}) \cdot \frac{R4}{R3} .$$

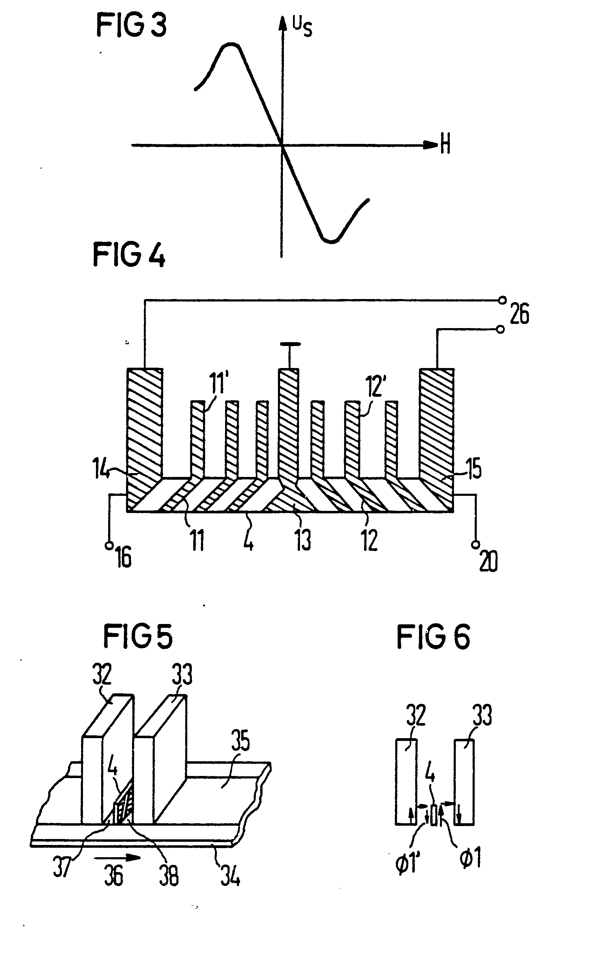

Die in Fig. 3 dargestellte Kennlinie des Sensors nach Fig. 1 oder Fig. 2 zeigt die Abhängigkeit des Sensorsignals $u_s$ von dem abgetasteten Magnetfeld H. Sie weist überall eine zum Schnittpunkt der Koordinatenachsen weitgehend symmetrische Form auf. Dies erklärt sich daraus, daß sich die geradzahligen Oberwellen der Sensorteilsignale $u_{s1}$ und $u_{s2}$ bei der Schaltung nach Fig. 1 oder Fig. 2 gegenseitig kompensieren, so daß sie $u_s$ nicht beeinflussen.

Fig. 4 zeigt eine Ausführungsform des Streifens 4, die für hohe Ströme $i_1$, $i_2$ geeignet ist. Dabei werden die Leiterbahnen 11, 12 durch Teile 11' und 12' über den Streifen 4 hinaus verlängert. Es wird insbesondere durch die Teile 11' und 12' eine bessere Wärmeableitung erzielt. Die genannten Teile 11' und 12' liegen dabei auf einem Substrat, das auch den Streifen 4 trägt.

0037966
80 P 7044 E

Der magnetoresistive Streifen 4 ist bei dem in Fig. 5 dargestellten Ausführungsbeispiel in den Spalt zwischen zwei Platten 32 und 33 aus ferromagnetischem Material eingesetzt, wie an sich aus den IEEE Transactions on Magnetics, Vol. MAG-12 (1976) auf den Seiten 716 bis 718 beschrieben ist. An diesen ortsfesten Teilen wird ein magnetischer Aufzeichnungsträger 34, der mit einer Informationsspur 35 versehen ist, in Richtung 36 vorbeibewegt. Dabei tastet der Streifen 4 die Differenz zweier unterschiedlicher Magnetflüsse $\emptyset 1$ und $\emptyset 1'$ an verschiedenen Stellen 37, 38 des Aufzeichnungsträgers 34 ab. Jeder dieser Flüsse überbrückt gemäß Fig. 6 einen der Teilspalte zwischen dem Streifen 4 und den Platten 32 und 33. Ein weiterer Unterschied des Sensors nach Fig. 5 besteht darin, daß sein Frequenzgang bei höheren Frequenzen des abzutastenden Magnetfeldes gegenüber dem Sensor nach den Figuren 1 und 2 angehoben ist, so daß er sich dem Frequenzverhalten eines induktiven Lesekopfes annähert.

Im Rahmen der Erfindung kann die Magnetisierung des Streifens 4 beim Nulldurchgang des abgetasteten Magnetfeldes auch durch ein zusätzliches äußeres Magnetfeld in eine einheitliche Richtung zurückgedreht werden, wie dies an sich bereits aus dem genannten Stand der Technik bekannt ist.

Die Anwendungsmöglichkeiten von magnetoresistiven Sensoren nach der Erfindung beschränken sich nicht auf die bereits beschriebene Anwendung zum Lesen der Informationsspuren bandförmiger Aufzeichnungsträger sowie plattenförmiger Träger, sondern umfassen auch das Messen von magnetischen Feldern ganz allgemein. Beim Einsatz als Leseköpfe für Informationsspuren stehen solche Anwendungen im Vordergrund, bei denen kleine Relativgeschwindigkeiten zwischen Lesekopf und Aufzeichnungs-

0037966
80 P 7044.0E

träger gegeben sind. Auch wenn viele schmale, dicht nebeneinander liegende Informationsspuren vorliegen, bringt der Einsatz von erfindungsgemäßen Sensoren große Vorteile, da sie leicht zu Vielfachleseköpfen integriert werden können.

8 Patentansprüche
6 Figuren

## Patentansprüche

1. Magnetoresistiver Sensor, bei dem ein stromdurchflossener Streifen aus ferromagnetischem Material vorgesehen ist, der eine in Richtung seiner Längsachse orientierte Magnetisierung aufweist und mit einem zu dieser senkrechten Magnetfeld beaufschlagt wird, bei dem ein erster Streifenabschnitt mit einer Mehrzahl von zueinander parallelen, zur Längsachse unter einem ersten Winkel verlaufenden Leiterbahnen versehen ist, während ein zweiter Streifenabschnitt entsprechende Leiterbahnen aufweist, die mit der Längsachse einen zweiten, sich mit dem ersten zu etwa $180^{\circ}$ ergänzenden Winkel einschließen, d a d u r c h  g e k e n n z e i c h n e t , daß die Streifenabschnitte (9, 10) von jeweils konstanten Strömen ($i_1$, $i_2$) in zueinander entgegengesetzten Richtungen durchflossen werden, wobei die die Ströme aufnehmenden (abgebenden) Enden beider Streifenabschnitte (9, 10) miteinander verbunden sind und die die Ströme abgebenden (aufnehmenden) *Enden* beider Streifenabschnitte mit Anschlüssen (26) zur Abnahme eines Sensorsignals ($u_s$) versehen sind.

2. Magnetoresistiver Sensor nach Anspruch 1, d a d u r c h  g e k e n n z e i c h n e t , daß die Streifenabschnitte (9, 10) endseitige Anschlüsse (13, 14; 13, 15) aufweisen, die mit den Streifenabschnitten individuell zugeordneten Konstantstromquellen (18, 19) beschaltet sind.

3. Magnetoresistiver Sensor nach Anspruch 2, d a d u r c h  g e k e n n z e i c h n e t , daß die Konstantstromquellen (18, 19) einstellbar ausgebildet sind.

0037966

4. Magnetoresistiver Sensor nach einem der Ansprüche 1 bis 3, d a d u r c h g e k e n n z e i c h n e t , daß die Anschlüsse (26) zur Abnahme eines Sensorsignals ($u_s$) mit den Eingängen eines Differenzverstärkers (28) beschaltet sind.

5. Magnetoresistiver Sensor nach einem der vorhergehenden Ansprüche, d a d u r c h g e k e n n z e i c h n e t , daß die Leiterbahnen (11, 12) über den Streifen (4) hinaus verlängert sind (11', 12').

6. Magnetoresistiver Sensor nach einem der vorhergehenden Ansprüche, d a d u r c h g e k e n n z e i c h n e t , daß der Streifen (4) in einem von zwei Platten (32, 33) aus ferromagnetischem Material zwischen sich begrenzten Spalt angeordnet ist.

7. Magnetoresistiver Sensor nach einem der vorhergehenden Ansprüche, g e k e n n z e i c h n e t d u r c h die Ver~~bindung~~ *wendung* zur Messung von Magnetfeldern.

8. Magnetoresistiver Sensor nach einem der Ansprüche 1 bis 6, g e k e n n z e i c h n e t d u r c h die Verwendung als Lesekopf zum Abtasten von Informations- spuren magnetischer Aufzeichnungsträger.

0037966

1/2

FIG 1

FIG 2

FIG 3

$U_S$

H

FIG 4

26

11'

12'

14

15

16

11

4

13

12

20

FIG 5

32

33

35

4

37

36

38

34

FIG 6

32

33

4

Ø1'

Ø1

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | <u>DE – A1 – 2 921 350</u> (SONY)<br>* Ansprüche 1 bis 3, 10, 11, 13;<br>  Seite 9, Zeilen 6 bis 10;<br>  Fig. 4, 7B *<br><br>-- | 1,4,<br>6,8 |
| | IBM TECHNICAL DISCLOSURE BULLETIN,<br>Band 21, Nr. 8, Januar 1979,<br>New York<br>K.H. ELSER et al. "Magnetoresistive<br>Head Assembly"<br>Seite 3341<br>* Seite 3341 *<br><br>-- | 1,8 |
| | IEEE TRANSACTIONS ON MAGNETICS,<br>Band MAG-15, Nr. 6, November 1979<br>New York<br>T.A. SCHWARZ et al. "Comparison of<br>Calculated and Actual Density Responses<br>of a Magnetoresistive Head"<br>Seiten 1622 bis 1624<br>* Zusammenfassung; Fig. 3, 4 *<br><br>-- | 6 |
| | IEEE TRANSACTIONS ON MAGNETICS,<br>Band MAG-11, Nr. 5, September 1975<br>New York,<br>R.D. HEMPSTEAD "Analysis of Thermal<br>Noise Spike Cancellation"<br>Seiten 1224 bis 1226<br>* Zusammenfassung *<br><br>--          ./.. | 4 |

**KLASSIFIKATION DER ANMELDUNG (Int. Cl.³)**

G 11 B    5/38

**RECHERCHIERTE SACHGEBIETE (Int. Cl.³)**

G 01 R    33/00
G 06 K    7/08
G 11 B    5/00

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde
   liegende Theorien oder
   Grundsätze
E: kollidierende Anmeldung
D: in der Anmeldung angeführtes
   Dokument
L: aus andern Gründen
   angeführtes Dokument
&: Mitglied der gleichen Patentfamilie, übereinstimmendes
   Dokument

| X | Der vorliegende Recherchenbericht wurde für alle Patentansprüche erstellt. |
|---|---|

| Recherchenort | Abschlußdatum der Recherche | Prüfer |
|---|---|---|
| Berlin | 03-07-1981 | ROGNONI |

EPA form 1503.1   06.78

| EINSCHLÄGIGE DOKUMENTE | | | KLASSIFIKATION DER ANMELDUNG (Int. Cl.³) · |
|---|---|---|---|
| Kategorie | Kennzeichnung des Dokuments mit Angabe, soweit erforderlich, der maßgeblichen Teile | betrifft Anspruch | |
| D | IEEE TRANSACTIONS ON MAGNETICS, Band MAG-12, Nr. 5, September 1976, New York J.C.V. LIER "Combined Thin Film Magnetoresistive Read, Inductive Write Heads" Seiten 716 bis 718 * Fig. 2 * | 5 | |
| A | DE – A1 – 2 923 863 (PHILIPS) * Seite 14, Zeilen 13 bis 18; Fig. 12 * | | **RECHERCHIERTE SACHGEBIETE (Int. Cl.³)** |